# EUROPEAN PATENT APPLICATION

(11) **EP 1 772 907 A2**
(43) Date of publication of application: **11.04.2007**
(21) Application number: 06121983.8
(22) Date of filing: 09.10.2006
(51) Int. Cl.: H01L 31/0224, H01L 31/068, H01L 31/18

(54) **Germanium solar cell and method for the production thereof**

(30) Priority: 07.10.2005 US 246509; 26.01.2006 US 340171
(71) Applicant: IMEC vzw, Interuniversitair Microelectronica Centrum vzw, 3001 Leuven (BE); Umicore N.V., 1000 Bruxelles (BE)
(72) Inventor: POSTHUMA, Niels, 3000, LEUVEN (BE); VAN DER HEIDE, Johan, 3200, AARSCHOT (BE); FLAMAND, Giovanni, 2520, OELEGEM (BE); POORTMANS, Jef, 3010, KESSEL-LO (BE)
(74) Representative: pronovem

(57) **Abstract**

The present invention is related to a method for passivating and contacting a surface of a germanium substrate, comprising:
a providing a germanium substrate having a first surface;
b. forming a passivation layer of an amorphous silicon material on the first surface;
c. forming a contact layer on the passivation layer, wherein the contact layer comprises a first metal layer, the first metal layer comprising at least one of palladium, copper and aluminium; and
d. heating the substrate and the layers so that the first surface makes contact with the contact layer through the passivation layer.

It moreover relates to passivated germanium substrates and photovoltaic devices produced by such methods.

## Description

### Field of the invention

The present invention relates to the field of germanium solar cells, germanium photovoltaic cells and germanium photodetectors.

### Background of the invention

The formation of contacts after the passivation of a germanium solar cell front side is not obvious. The properties of the germanium substrate and possibly passivation layer should not be altered significantly during this process, which limits process conditions as for instance processing temperatures (preferably kept below 300°C).

In EP-A-1475844, a method is disclosed for the passivation and contacting of a surface of a germanium substrate, comprising the steps of providing said germanium substrate with a first surface; producing a passivation layer of amorphous silicon material on said first surface; producing a contact layer of metal on said passivation layer; applying a diffusion step, such that said germanium surface is contacted by said contact layer, through said passivation layer. Also passivated Ge-substrates comprising metal contacts obtained by said diffusion step are shown.

Some of the embodiments disclosed can be improved and alternatives are welcome in the domain.

### Aim of the invention

It is an aim of this invention to provide for a method for producing passivated germanium substrates, which alleviates or avoids the problems of the prior art or provides an alternative to the prior art.

### Summary of the invention

Various aspects provide a novel method for passivating and contacting a germanium surface. The germanium surface is preferably a surface of a germanium solar cell, a germanium thermo photovoltaic cell, or a germanium photodetector. It can be, for instance, the front or back surface of the solar cell. The front side or front surface is defined as the side adapted for receiving the largest amount of radiation from the sun or other radiation source(s) during use. The backside or back surface is defined as the opposite surface from the front surface. The backside typically receives no or a limited amount of radiation during typical use.

Other aspects provide a novel highly efficient germanium solar cell and a method for producing such a cell.

As a first object, a method of passivating and contacting a surface of a germanium substrate, is disclosed comprising the following steps:
(a) providing a germanium substrate having a first surface;
(b) depositing or forming a first layer of an amorphous silicon material on said first surface in order to form a passivation layer;
(c) depositing or forming a second layer on said first layer in order to form a contact layer, said contact layer comprising a first metal layer, the first metal layer comprising at least one element selected from the group consisting of palladium, copper and aluminium; and
(d) heating the substrate and the layers there on so that the first surface makes contact with the contact layer through the passivation layer.

The contact resistivity of a conductive path between the contact layer and the substrate is preferably less than about 10⁻⁴Ωcm².

The method can further comprise the step of cleaning the first surface before forming the passivation layer. The cleaning step can comprise applying a H₂ containing plasma to the first surface. The cleaning step can comprise applying a wet-chemical HF dip to the first surface.

The forming the passivation layer can be performed by plasma enhanced chemical vapor deposition. The plasma enhanced chemical vapor deposition can be performed at a temperature of from about 150°C to about 300°C.

The step of heating the layers can be performed locally in a predetermined contact area. The local heating can be performed by a laser.

The heating can be performed at a temperature lower than about 500°C , lower than about 400°C, lower then about 300°C.

The heating can be performed at a temperature of from about 180°C to about 240°C.

The passivation layer has preferably a thickness of less than about 500 nm, more preferably less than 300nm, even more preferably less than 100 nm.

The passivation layer can even more preferably have a thickness of less than about 80 nm, or less than about 40 nm.

The passivation layer can preferably have a thickness of from about 10 nm to about 50 nm or from about 10nm to about 40 nm. The passivation layer can have a thickness of from about 20 nm to about 100 nm, eg about 15nm, about 20 nm, about 25nm, about 30nm, about 35nm, about 40nm, about 50nm, about 60nm, about 70nm, about 80nm, about 90nm.

The contact layer is preferably comprising Pd and can further comprise an additional metal layer, the additional metal layer being or comprising at least one the elements selected from the group consisting in Cu, Ag, and Au.

The first metal layer is preferably deposited atop the passivation layer, and the additional metal layer is deposited atop the first metal layer.

The first metal layer can comprise or essentially consist of aluminium when the first surface is configured to be used as a back surface of a photovoltaic device.

The contact layer can be a continuous layer configured for use as a mirroring surface for the back surface.

The method can further comprise the deposition of a barrier layer between said passivation layer and said contact layer.

The barrier layer can comprise ZnS, MgF₂, SiOₓ, as eg SiO₂, SiₓN_{y}, as eg Si₃N₄ or a combination thereof.

As a second object, a passivated germanium substrate is disclosed, comprising:
- a germanium substrate comprising a first surface;
- a passivation layer comprising an amorphous silicon material formed on the first surface; and
- a metal contacting layer on the passivation layer, the metal contacting layer contacting the substrate through the passivation layer, by particles of the metal that are penetrated into the passivation layer to form a conductive path between the contacting layer and the germanium substrate, wherein the contacting layer comprises a first metal layer, the first metal layer comprising at least one element selected from the group consisting of palladium, copper and aluminium.

The passivation layer can be deposited and the deposition can preferably be performed by plasma enhanced chemical vapor deposition (PECVD). The passivation layer can comprise a conductive material in an area underlying the contacting layer and between the contacting layer and the germanium substrate.

The passivation layer can have a thickness of from about 10 nm to about 40 nm, especially when applied on front sides of photovoltaic devices. The passivation layer can have a thickness of from about 20 nm to about 100 nm, especially when applied on back sides of photovoltaic devices.

As a third object, a photovoltaic device is disclosed comprising:
- a germanium substrate having a first surface and a second surface;
- a first passivation layer comprising amorphous silicon material formed on the first surface;
- a second passivation layer comprising amorphous silicon material formed on the second surface;
- a first contacting layer comprising a conductive material formed on the first passivation layer, wherein the first contacting layer comprises aluminium; and
- a second contacting layer comprising a conductive material formed on the second passivation layer, wherein the second contacting layer comprises a metal selected from the group consisting of Pd, Cu, Ag, and Au.

The photovoltaic device can preferably comprise a barrier layer in between said contact layer and said first passivation layer.

This barrier layer can comprise or consist of for instance ZnS, MgF₂, SiOₓ, as eg SiO₂, SiₓN_{y}, as eg Si₃N₄ ,or a combination thereof.

As a fourth object, a method of passivating and contacting a surface of a germanium substrate is disclosed, comprising:
- providing a germanium substrate having a first surface;
- forming a passivation layer of an amorphous silicon material on the first surface;
- forming a contact layer on the passivation layer, wherein the contact layer comprises a first metal layer,
- heating the substrate and the layers so that the first surface makes contact with the contact layer through the passivation layer, wherein heating the substrate and the layers is performed locally, in a predetermined contact area.

The heating can be performed by a laser.

The contact layer can be a continuous layer configured for use as a mirroring surface for the back surface.

### Description of the figures

Fig. 1 illustrates the process steps of fabrication of a germanium solar cell passivated by the method according to the present invention according to preferred embodiments described in detail in the specification.

Fig. 2 illustrates the performance of a solar cell according to a preferred embodiment. As shown in the current-voltage characteristic shown in Fig. 2, the short circuit current (J_{sc}) is equal to 40.4 mA/cm², the open circuit voltage Voc is equal to 248 mV and the fill factor (FF) is found to be 66.3%. An AM1.5 efficiency of 6.64 % is measured.

Fig. 3 illustrates the internal quantum efficiency, the external quantum efficiency, and the reflectance of a solar cell created by a preferred embodiment of the present invention, in function of the wavelength of the incoming light. The good quality of the passivation layer is shown by the excellent response at low wavelengths.

Fig. 4 shows simulation results where the emitter thickness and surface recombination velocities have been varied.

Fig. 5 is the carrier lifetime is plotted in function of the duration of the exposure time of the substrate to the H₂ plasma during the preliminary cleaning step.

Fig. 6 illustrates the process of achieving laser fired contacts (LFC), according to embodiments of the present invention.

Fig. 7(a) through (c) provides SEM pictures of an Al-a-Si-Ge interface where a laser beam has been applied. In Fig. 7(a) the power was about 0.4W, whereas it was about 1W in Fig. 7(b) and 0.6W in Fig. 7(c).

Figs. 8(a) and 8(b) provide results of a transfer length method (TLM) measurement and I-V characteristics of a LFC substrate, respectively.

Fig. 9 provides a measurement of the reflection of germanium substrates covered with different metals at the back.

Fig. 10 is an overview of the several steps of a process for fabricating a germanium solar cell suited for application in a thermophotovoltaic device (so-called LFC cell).

Fig. 11 is representing the IV-characteristics of the germanium LFC solar cell, measured using the AM1.5 spectrum.

Fig. 12 is describing the quantum efficiency of a germanium photovoltaic cell using a LFC back contact.

Fig. 13 is describing a normalized external quantum efficiency (EQE) and reflection of a laser fired cell (cell B) and a classical contacted germanium solar cell.

Fig. 14 is representing the IV-characteristics of a diced germanium photovoltaic cell with a full aluminium rear contact, measured using the AM1.5 spectrum.

### Detailed description of preferred embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

The term "comprising" as used herein is synonymous with "including," "containing," or "characterized by," and is inclusive or open-ended and does not exclude additional, unrecited elements or method steps.

A method for passivating and contacting a germanium substrate is disclosed comprising a) providing a germanium substrate with a first surface; this germanium surface can be doped or undoped; b) depositing a layer of amorphous silicon on top of the germanium surface. Advantageously plasma enhanced chemical vapor deposition (PECVD) is used for deposition. Other state of the art techniques are possible. Preferably, the thickness of the layer is generally less than 500 nm. More preferably, the thickness of the layer is less than 300 nm. Even more preferably, the thickness of the layer is less than about 100 nm. Most preferably, for front surface applications, the thickness of the layer is less than about 40 nm. Advantageously for efficient solar cell front surface applications, the thickness of the layer is from about 10 to about 40 nm, e.g., from about 15 nm, 20 nm, or 25 nm to about 30 nm, 35 nm, or 40 nm. For back surface applications the thickness can typically be larger, since the effect of absorption of incident light on the performance is minimal. The thickness is preferably from about 20 nm to about 100nm. More preferably the thickness is from about 40 nm to about 90 nm. Even more preferably the thickness is from about 50 nm to about 80 nm. If the thickness becomes too large, it may become more difficult to diffuse/fire the contact metal through the layer. Of particular note is the cleaning treatment preceding the deposition, gas flow composition and applied RF-power for forming the plasma. Preferably, the PECVD is performed at a wafer temperature of from about 150°C to about 250°C or 300°C, e.g., from about 160°C, 170°C, 180°C, 190°C, 200°C, or 210°C to about 220°C, 230°C, 240°C, 250°C, 275°C, or 300°C. A higher deposition temperature results in out-diffusion of the hydrogen within the material, which subsequently results in less desirable passivation properties; c) depositing a patterned layer of metal on top of the layer of amorphous silicon. This can be done by any state of the art technique. Preferably the metal is a highly conductive metal such as Pd, Cu, Ag, Au or Al. Pd, Cu, Ag, and Au are advantageously used in front surface applications, while Al can advantageously be used for backside passivation schemes. In backside passivation schemes, the aluminium can generate a back surface field (BSF), which would not be desirable on the front surface; if employed in front surface applications, Al could possibly form a p++ region which repels the holes at the front side, preventing collection of the holes on the front. Also, a multi-layer comprising two or more different metal layers can be applied, such as Pd/Ag, Pd/Au, or Pd/Cu. This step can comprise different sub steps. This layer can be patterned to form a contact grid; and d) "Firing through" or diffusion of the metal through the layer of amorphous silicon by applying a temperature step, such that the germanium surface is contacted. The diffusion step should be chosen such that the process can be controlled. The effect of the diffusion or fire through is that metal particles of the contact layer penetrate through the amorphous silicon passivation layer to form a conductive path between the contact and the Ge-substrate. The resulting contacting resistivity is preferably lower than 5.10⁻⁴Ωcm², more preferably lower than 10⁻⁴Ωcm², most preferably lower than 10⁻⁵Ωcm². The quality of the passivation layer is strongly affected by the cleaning treatment preceding the deposition. For instance a wet-chemical HF-dip and a H₂ plasma can be used to prepare the surface.

A method of passivating and contacting a surface of a germanium substrate is provided, including:
(a) providing a germanium substrate having a first surface;
(b) forming a passivation layer of amorphous silicon material on the first surface;
(c) forming a contact layer of metal on the passivation layer;
(d) heating the substrate and layers so that the first surface makes contact with the contact layer through the passivation layer.

The contact resistivity is preferably less than about 10⁻⁴Ωcm².

The method can further include cleaning the first surface before forming the passivation layer, the cleaning including applying wet-chemical HF treatment and a H₂ containing plasma to the first surface.

Forming the passivation layer can be performed by plasma enhanced chemical vapor deposition (PECVD).

The PECVD can be performed at a temperature of from about 150°C to about 300°C.

The passivation layer can have a thickness of less than about 100 nm.

The passivation layer can have a thickness of less than about 40 nm.

The passivation layer can have a thickness of from about 10 nm to about 50 nm.

The first surface can be a surface of a germanium solar cell, a thermo photovoltaic cell, or a photodetector.

The contact layer includes Ag, Au, Pd, or Cu. The contact layer can also comprise a multi-layer, as for instance Pd/Ag, Pd/Au, or Pd/Cu multi-layers.

The contact layer can be patterned to form a contact grid.

The heating can be performed at a temperature lower than about 300°C.

The heating can be performed at a temperature of from about 180°C to about 240°C.

The method can further include (a) forming an emitter area in the germanium substrate; (b) forming a back contact on a second surface of the germanium substrate and thereby realizing a back surface field; (c) etching mesa structures so as to define photo voltaic cell regions; and (d) forming an antireflective coating on the exposed parts of the passivation layer and the contact layer.

The forming of an emitter area, forming a back contact, and etching mesa structures can be performed before forming a passivation layer.

Forming an antireflective coating can be performed after the heating step.

A passivated germanium substrate is disclosed, including a germanium substrate including a first surface; a passivation layer of plasma enhanced chemical vapor deposition (PECVD) deposited amorphous silicon material formed on the first surface; and a metal contacting layer on the passivation layer contacting the substrate through the passivation layer, by particles of the metal having penetrated into the passivation layer and thereby having formed a conductive path between the contacting layer and the germanium substrate.

The passivation layer preferably includes a conductive material in an area underlying the contacting layer and between the contacting layer and the germanium substrate.

The passivation layer has a thickness of from about 10 to about 40 nm.

A photovoltaic device is disclosed including a germanium substrate including a first surface; a passivation layer of plasma enhanced chemical vapor deposition (PECVD) deposited amorphous silicon material formed on the first surface; and a contacting layer including a conductive material formed on the passivation layer.

A method of passivating and contacting a surface of a germanium substrate is disclosed, comprising: providing a germanium substrate having a first surface; cleaning the first surface by applying a wet-chemical HF dip to the first surface and thereafter applying a H₂ containing plasma to the first surface; forming a passivation layer of amorphous silicon material on the first surface; forming a contact layer of metal on the passivation layer; and heating the substrate and the layers so that the first surface makes contact with the contact layer through the passivation layer. The method can further comprise forming an emitter area in the germanium substrate; forming a back contact on a second surface of the germanium substrate and thereby realizing a back surface field; etching mesa structures so as to define photo voltaic cell regions; and forming an antireflective coating on the exposed parts of the passivation layer and the contact layer.

A method of passivating and contacting a surface of a germanium substrate is provided, comprising providing a germanium substrate having a first surface, wherein the first surface is configured to be used as a back surface of a photovoltaic device; forming a first passivation layer comprising an amorphous silicon material on the first surface; forming a contact layer on the first passivation layer, wherein the contact layer comprises a first metal layer, the first metal layer comprising aluminium; and heating the substrate and the layers so that the first surface makes contact with the contact layer through the first passivation layer.

The first metal layer can comprise or consist essentially of aluminium.

Heating the substrate and the layers can be performed locally, in a predetermined contact area. The heating can be performed by means of a laser.

The contact layer can be a continuous layer configured for use as a mirroring surface for the back surface.

The contact resistivity of a conductive path between the contact layer and the substrate is preferably less than about 10⁻⁴Ωcm².

The method can further comprise cleaning the first surface before forming the first passivation layer, the cleaning comprising applying a H₂ containing plasma to the first surface.

The method can further comprise cleaning the first surface before forming the first passivation layer, the cleaning comprising applying a wet-chemical HF dip to the first surface.

The first passivation layer can be performed by plasma enhanced chemical vapor deposition.

The plasma enhanced chemical vapor deposition is preferably performed at a temperature of from about 150°C to about 300°C.

The first passivation layer has preferably a thickness of less than about 100 nm.

The first passivation layer can preferably have a thickness of less than about 80 nm. The first passivation layer can have a thickness of from about 20 nm to about 100 nm.

A photovoltaic device can obtained by the methods described according to the present invention, wherein the photovoltaic device is selected from the group consisting of a solar cell, a thermo photovoltaic cell, and a photodetector.

The contact layer can further comprise an additional metal layer, the additional metal layer comprising or consisting of at least one metal selected from the group consisting of Cu, Ag, and Au.

The first metal layer can be deposited atop the first passivation layer, wherein the additional metal layer is deposited atop the first metal layer. The additional metal layer can be deposited by evaporation, or by electroplating.

The contact layer can be patterned to form a contact grid.

The heating is preferably performed at a temperature lower than about 300°C.

The heating can be performed at a temperature of from about 180°C to about 240°C.

The method can further comprise forming an emitter area in the germanium substrate; forming a second passivation layer comprising an amorphous silicon material on a second surface of the germanium substrate, wherein the second surface is configured for use as front surface of a photovoltaic device; forming a front contact layer on the second passivation layer, wherein the front contact layer comprises a second metal layer; and heating the substrate and the layers so that the second surface makes contact with the front contact layer through the second passivation layer. The second metal layer can comprise a metal selected from the group consisting of Pd, Cu, Ag, and Au. Only one heating step can be performed for the front surface and the back surface. The second surface can make contact with the front contact layer through the second passivation layer before the first surface makes contact with the contact layer through the first passivation layer.

A passivated germanium substrate is disclosed, comprising a germanium substrate comprising a first surface; a passivation layer comprising an amorphous silicon material formed on the first surface; and a metal contacting layer on the passivation layer, the metal contacting layer contacting the substrate through the passivation layer, by particles of the metal that are penetrated into the passivation layer to form a conductive path between the contacting layer and the germanium substrate, wherein the contacting layer comprises a first metal layer, the first metal layer comprising aluminium.

The amorphous silicon material can be deposited by for instance and preferably plasma enhanced chemical vapor deposition.

The passivation layer preferably comprises a conductive material in an area underlying the contacting layer and between the contacting layer and the germanium substrate.

The passivation layer has preferably a thickness of from about 20 nm to about 100 nm.

A photovoltaic device is provided comprising a germanium substrate having a first surface; a passivation layer comprising an amorphous silicon material formed on the first surface; and a contacting layer comprising a conductive material formed on the passivation layer, wherein the contacting layer comprises a first metal layer, the first metal layer comprising aluminium.

The amorphous silicon material can be deposited by plasma enhanced chemical vapor deposition.

A photovoltaic device is disclosed comprising a germanium substrate having a first surface and a second surface; a first passivation layer comprising amorphous silicon material formed on the first surface; a second passivation layer comprising amorphous silicon material formed on the second surface; a first contacting layer comprising a conductive material formed on the first passivation layer, wherein the first contacting layer comprises aluminium; and a second contacting layer comprising a conductive material formed on the second passivation layer, wherein the second contacting layer comprises a metal selected from the group consisting of Pd, Cu, Ag, and Au.

The amorphous silicon material can be deposited, for instance and preferably by plasma enhanced chemical vapor deposition.

Advantageously, the photovoltaic device can preferably comprise a barrier layer in between the contact layer and in particular the back contact layer, made of aluminium and the passivation layer just underneath. Said barrier layer is accordingly a layer that is deposited between the amorphous silicon layer (passivation layer) and the aluminium layer (back contact layer). The preferred material for said barrier layer can be MgF₂ (through e-beam evaporation), ZnS (through e-beam evaporation),SiOₓ as eg SiO₂ (through PEC) and SiₓN_{y}, as eg Si₃N₄ (through PEC.

This barrier layer has two functions:
1) Improving the mirror properties of the backside. By adjusting the thickness, one can obtain a higher reflection, because of the difference in breaking index with the amorphous silicon layer
2) As a diffusion barrier: when no barrier layer is deposited at the backside, the aluminium diffuses through the amorphous silicon during the diffusion of the front layer contact. This is not desirable, because we would like to define local contact areas for the laser and therefore it is necessary to have contact only on specific areas. Moreover, the passivating properties of amorphous silicon decrease when it contains aluminium. By applying an extra material between Al and amorphous silicon, this problem will be solved.

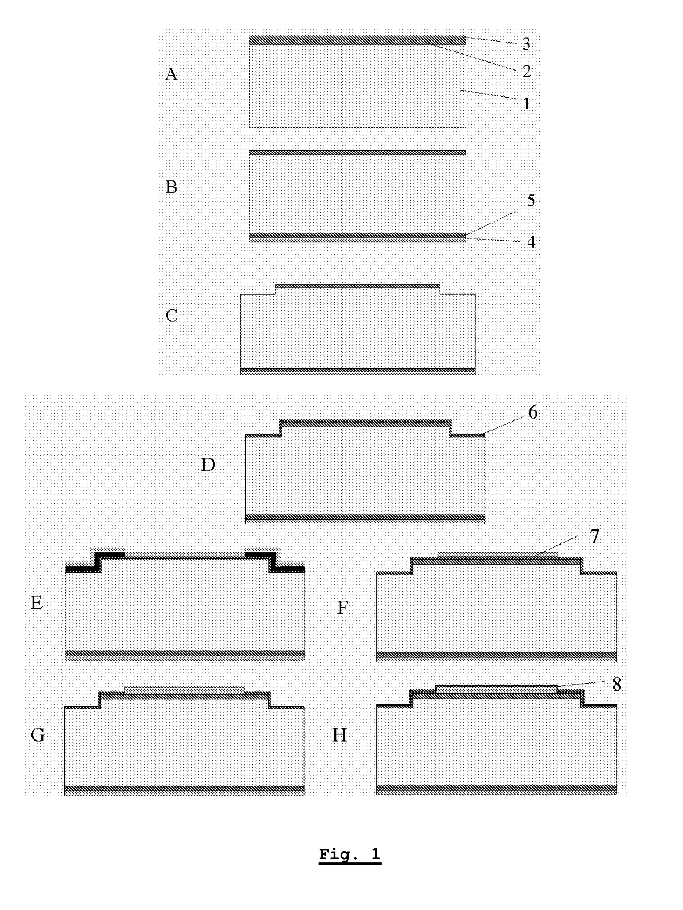

According to a preferred embodiment a method for the production of a germanium solar cell is described in detail referring to the steps disclosed in Fig.1.

### Step A.

Providing a p-type (or alternatively n-type) germanium substrate (1); and forming the emitter (n⁺ region, 2) in the p-type germanium substrate, by means of diffusion using a source of spin-on dopant (3) (SOD, preferably comprising phosphorous (P)). A possible alternative is the reversed situation with a p⁺ emitter in the n-type substrate. The most relevant parameters are the diffusion time, diffusion temperature, diffusion atmosphere, and the phosphorous content of the SOD. The diffusion temperature is preferably from about 500 to about 700°C. More preferably a temperature of about 600 °C is used. The diffusion time is preferably from about 10 seconds to about 20 minutes. More preferably a diffusion time of about 30 seconds is used. The diffusion atmosphere is preferably a forming gas such as N₂+H₂ (10%). Subsequent to the diffusion the spin-on material is removed using an HF solution.

### Step B.

Application of the back contact (4) and formation of the back-surface field (BSF), using preferably aluminium applied by evaporation. Subsequently the Al is diffused into the substrate by applying a temperature step in a forming gas (preferably N₂+H₂(10%)) to create a p⁺ zone that serves as a back surface field (BSF) (5). Preferably an about 1 µm thick aluminium layer is evaporated. The diffusion temperature is preferably from about 350 to about 600°C. The diffusion time is preferably from about 10 minutes to about 60 minutes. The diffusion atmosphere is preferably a forming gas such as N₂+H₂ (10%).

### Step C.

Defining the solar cell area by etching the mesa structures.

### Step D.

Passivation of the front side by applying a very thin layer of intrinsic hydrogenated amorphous silicon (Si:H) (6) using plasma enhanced chemical vapor deposition (PECVD). Preferably the surface is prepared by a wet-chemical treatment using HF and subsequently applying a H₂ plasma, inside the deposition chamber, performed just before the deposition of the amorphous silicon. Preferably the applied RF power is less than 50 Watt. More preferably the power is less than 15 Watt. The exposure time is preferably less than 2 minutes; more preferably the exposure time can be chosen between 30 and 45 seconds. Preferably the thickness of the layer is less than about 100 nm. More preferably a thickness of smaller than about 50 nm or about 40 nm can be chosen. For solar cell and thermophotovoltaic cell applications, a thickness of about 10 nm to about 40 nm or 50 nm can be chosen, which can be especially advantageous when considering front side passivation schemes. For backside passivation schemes, the thickness is preferably greater, as described above. Thicker layers may absorb too much light, which can be disadvantageous when a high efficiency of a solar cell is important. Gas flow composition and applied RF-power are critical for forming the plasma. Preferably the PECVD is performed at a wafer temperature of from about 150 to about 250°C. Preferably the plasma is from about 6 to about 20 Watts. Preferably the gas composition comprises from about 20 to about 100 sccm SiH₄ and from about 0 to about 600 sccm H₂.

### Steps E and F.

Application of the front contact by evaporation of the metal, preferably silver (Ag) copper (Cu) or gold (Au) contact structure (E), using preferably lift-off to define the finger pattern (F,7). For instance an about 2 µm thick metal layer can be used. Alternatively a multi-layer of different types of metal can be used like Pd/Ag, Pd/Cu, or Pd/Au. The material of the first layer, preferably Pd, is diffused through the passivation layer to obtain a low contact resistance. The second, preferably highly conductive metal layer such as Ag, Cu or Au, serves to obtain a low series resistance. The second layer can be evaporated or applied by electro-plating. For instance a multi-layer comprising a 50 nm layer and a 2 µm layer can be applied. Cu as a second layer in the multilayer can be advantageous since it can be applied via electroplating and thus allow formation of thick layers (e.g., thicker then 2 microns), which can be desirable in applications where high currents are generated, as in, for instance, thermophotovoltaic systems or concentrator systems.

### Step G.

Firing through the amorphous silicon layer of the applied metal contacts (diffusion of the metal through the passivating amorphous silicon layer) in order to obtain a good contact with the n⁺ germanium emitter. Critical are the diffusion time and temperature. The diffusion temperature is preferably from about 150 to about 300°C, for instance, about 220°C. More preferably a temperature of from about 160 or 170 °C to about 250 °C is used, and most preferably, a temperature of from about 180 °C to about 230 °C or 240 °C is used. The diffusion time is preferably between 1 min and 60 min. Depending on the thickness of the passivation layer, the optimal diffusion time will change. The diffusion atmosphere is preferably a forming gas (as N2 + H2 (10%)).

### Step H.

Evaporation of the anti-reflective coating (8) using preferably zinc sulfide (ZnS) and magnesium fluoride (MgF₂).

According to another preferred embodiment, a method for the production of a germanium solar cell is described referring to the same steps represented in Fig. 1:

### Step A.

Providing a p-type germanium substrate (1) and forming the emitter (n⁺ region, 2) in the p-type germanium substrate, by means of diffusion using a source of spin-on dopant (3). A diffusion temperature of 600 °C and a diffusion time of 30 seconds were used. The diffusion atmosphere was a forming gas, N₂+H₂ (10%).

### Step B.

Application of the back contact (4) and realization of the back-surface field (BSF) (5), using aluminium applied by evaporation. Subsequently the Al is diffused into the substrate by applying a temperature step in forming gas (N₂+H₂(10%)) to create a p⁺ zone that serves as a back surface field (BSF) (5). A 1 µm thick aluminium layer was evaporated. The diffusion temperature was between 350 and 600°C. The diffusion time is between 10 minutes and 60 minutes. The diffusion atmosphere is a forming gas N2+H2 (10%).

### Step C.

Defining the solar cell area by etching the mesa structures.

### Step D.

Passivation of the front side by applying a very thin layer of intrinsic hydrogenated amorphous silicon (Si:H) (6) using plasma enhanced chemical vapor deposition (PECVD) at a substrate temperature of 170 °C. A layer with thickness of 10 nm was deposited. The plasma power was between 6 and 20 Watts. The gas composition was comprised between 20 to 100 sccm SiH₄ and between 0 to 600 sccm H₂. The surface is prepared by a wet-chemical HF treatment and a H₂ plasma.

### Steps E and F.

Application of the front contact by evaporation of the palladium (Pd) silver (Ag) multi-layer contact structure (E), using lift-off to define the finger pattern (F,7). The lift off comprised selectively depositing a resist layer on the layer of amorphous silicon before the Pd/Ag deposition. After the following Pd/Ag deposition the resist is removed - together with the Pd/Ag deposited on the resist, such that only the area where no resist had been applied remains covered with Ag. A 50 nm palladium and a 2 µm thick silver layer were used.

### Step G.

Firing through the amorphous silicon layer of the applied Pd/Ag contacts (diffusion of palladium through the passivating amorphous silicon layer) in order to obtain a good contact with the n⁺ germanium emitter. Critical are the diffusion time and temperature. A diffusion temperature of 220 °C and a diffusion time of about 2 to 20 minutes were used. The diffusion atmosphere was a forming gas (N2 + H2 (10%)).

### Step H.

Evaporation of the anti-reflective coating (8) using zinc sulfide (ZnS) and magnesium fluoride (MgF₂).

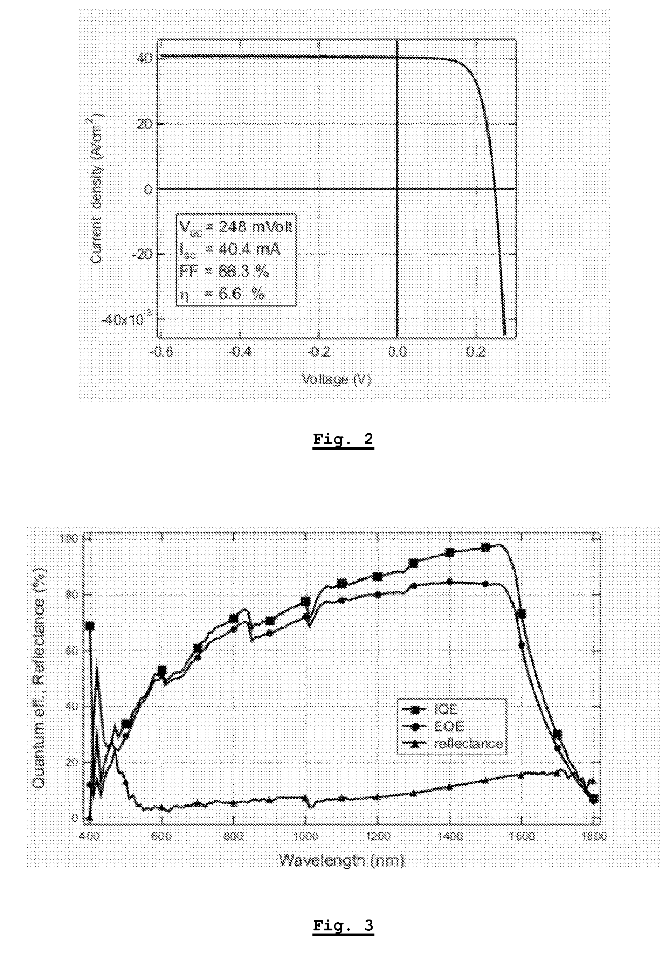

Fig. 2 illustrates the performance of a solar cell according to a preferred embodiment of the present invention. As shown in the current-voltage characteristic shown in Fig. 2, the short circuit current (J_{sc}) is equal to 40.4 mA/cm², the open circuit voltage Voc is equal to 248 mV and the fill factor (FF) was found to be 66.3%. An AM1.5 efficiency of 6.64 % was measured.

Fig. 3 illustrates the internal quantum efficiency, the external quantum efficiency, and the reflectance of a solar cell created by a preferred embodiment of the present invention, in function of the wavelength of the incoming light.

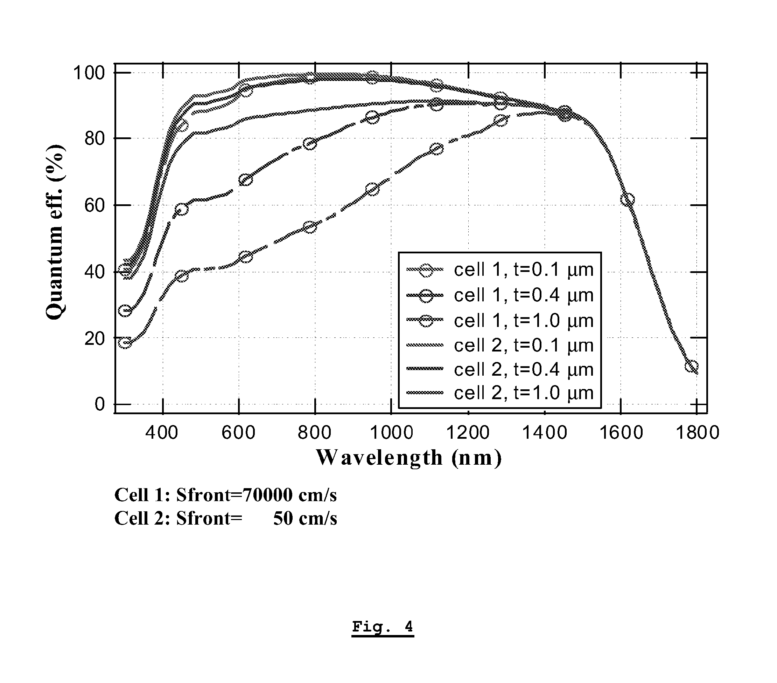

Important for the fabrication of a germanium cell with efficiencies as shown by the cell obtained by application of the techniques of the preferred embodiments, is thickness of the emitter and the applied surface passivation technique. Fig. 4 shows simulation results where the emitter thickness and surface recombination velocities have been varied. Cell 1 has a simulated front surface recombination velocity (S_{front}) of 70000 cm/s and cell 2 has S_{front} equal to 50 cm/s. With decreasing emitter depth and decreasing recombination velocity at the front surface the response of the cell improves.

After passivating the backside using PECVD amorphous silicon, a 1 µm thick metal contact layer can be deposited by evaporation. Subsequently, the metal can be heated locally by applying a laser pulse. For this application, a green (532nm) YAG laser can be employed; however, other lasers can also be employed. The heating generated by the laser pulse results in the diffusion of the metal through the amorphous silicon and inside the germanium layer forming the contact. Aluminium is advantageous for back surface contacting, because aluminium dopes the germanium and thereby forms a local p⁺ layer at the contact that acts as a back surface field. Aluminium also exhibits good reflective properties.

The power of the laser is chosen such that it can be used in the processes as described above. Therefore several parameters can be adjusted as desired. Some parameters that can be adjusted include the current through the laser diode, the moving speed of the laser head, and the focusing of the laser beam.

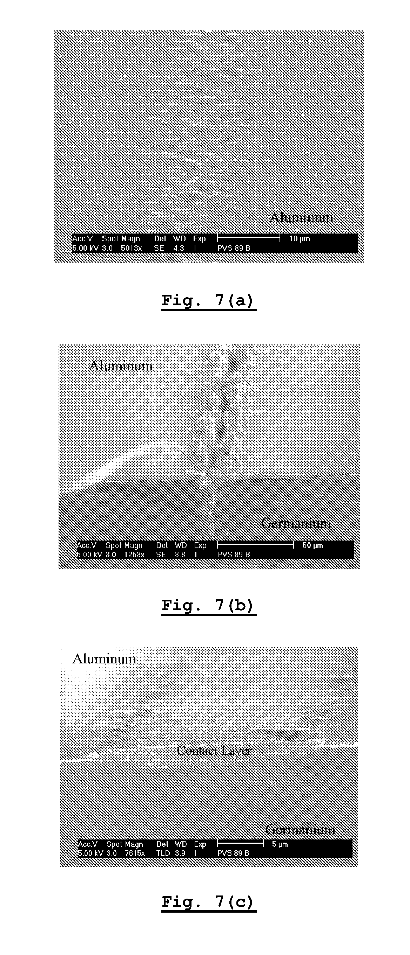

By changing these parameters the power of the laser beam that the substrate is exposed to can be tuned. In Figure 7, three SEM pictures are displayed where the influence of the laser power is shown. In Figure 7(a) the power of about 0.4W was too low to make contact, while Figure 7(b) shows that a laser beam of about 1 Watt seriously damaged the surface. Further tests have been carried out where the laser power was varied. In Figure 7(c), a laser beam with a power of about 0.6 Watt was applied and achieved acceptable results. The diode current was 20 A, the propagation speed of the laser beam was 500 mm/min, and the stage was 0.250 mm out of focus. The laser frequency was about 100 kHz. The cross-section in Figure 7(c) shows a connection between the upper layer (aluminium) and the germanium substrate.

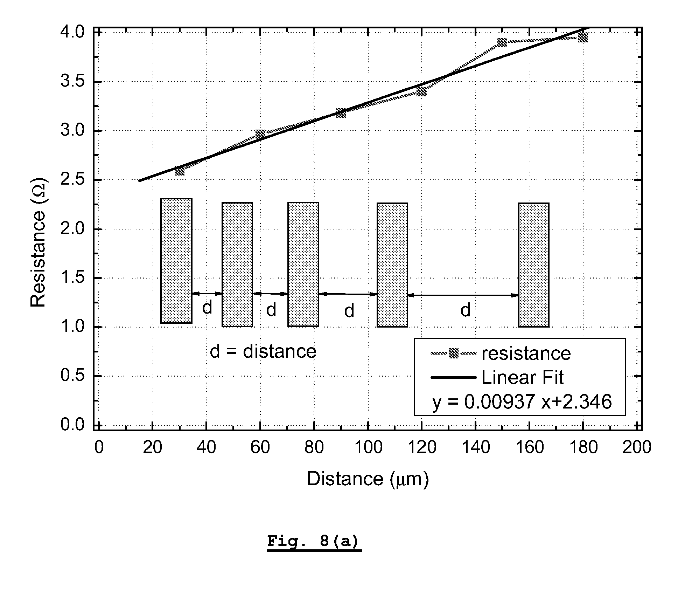

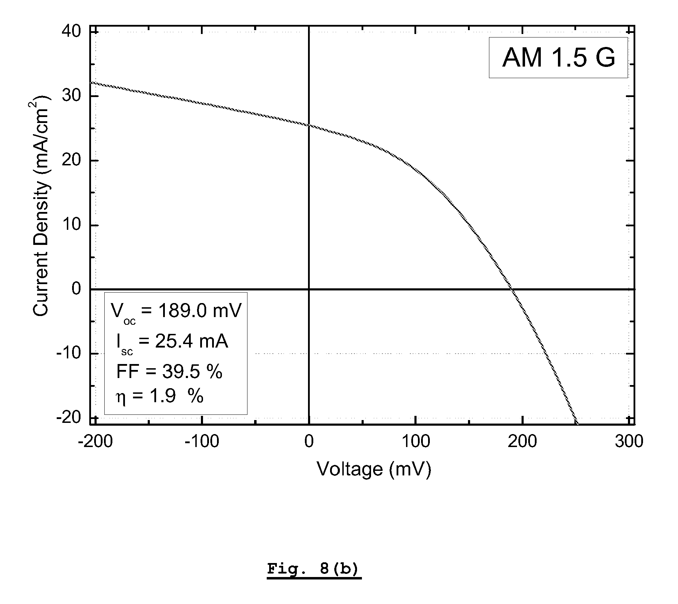

The contact resistance was measured for the contact shown in Figure 7(c) using the transfer length method. In this measurement, the resistance between two contact points was measured over several increasing distances and the results are shown in Figures 8(a) and 8(b). The resistance showed an Ohmic character. Based on the results of the measurement of the contact shown in Figure 7(c), a specific contact resistance of about 7.6.10⁻⁴Ω-cm is calculated, which makes this technique suitable for TPV applications.

Using the structure shown in Fig. 7(c), a first-time germanium TPV cell has been developed using LFC. It is believed that the laser lines as a contact grid at the back can be further optimized, improving the device, for example, by improving the Fill Factor (FF). Solar cell behavior has also been observed. The measured values of V_{oc} = 189 mV, J_{sc} = 25.4 mA, FF = 39.9% and η = 1.9% demonstrate the applicability of LFC in germanium TPV cells.

As discussed above, the methods for passivating and contacting according to the preferred embodiments can be applied to the front surface as well as to the back surface of the photovoltaic device, thus also to both surfaces. This results in corresponding devices. In certain embodiments wherein both front surface and back surface are processed according to methods of the preferred embodiments, a single firing step can be performed for firing front as well as back contacts. The amorphous layer can in certain embodiments be applied to both sides at the same time, in a single step. This can be done by a proper design of the deposition chamber and/or choosing certain orientations of the Ge wafers. In a typical chamber the wafers can be placed at an angle with respect to the horizontal direction (defined as orthogonal to the direction of gravity), as, for example, vertical (*i.e*., an angle of 90 degrees).

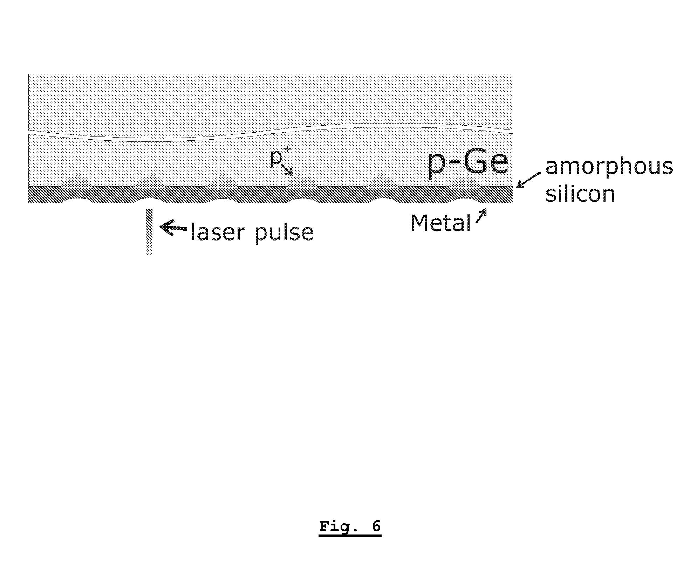

In the preferred embodiments illustrated in Fig. 6, the firing step can be performed locally (*e.g*., defining a pattern), for example, by use of a laser. The use of a laser allows for local heating. The methods of these embodiments are particularly desirable in the case of back surface applications, where patterning of the metal layer is not necessary. When applying a heating step, a eutectic alloy (*e.g.*, GeAl on the back surface) is formed, which forms the contacts. The regions where these eutectic alloys are present have been found to be less reflective. Therefore, methods of certain preferred embodiments, advantageously useable for backside applications, do not produce a patterned metal layer, but instead a continuous layer which serves as a reflector, also called mirror surface. A local heating by, for example, a laser can provide a good contact pattern, and leaves the remaining Ge/Al interface as is, such that its reflecting properties are not jeopardized.

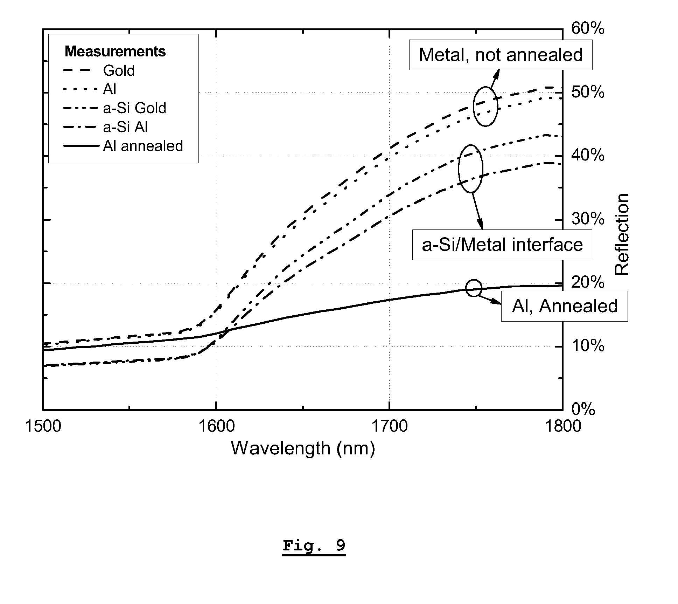

Fig. 9 shows some measurements which illustrate the reflection properties, measured from the font, of a 90 µm germanium substrate covered on the backside with, respectively, gold, silver, amorphous silicon-gold, amorphous silicon-silver and an annealed (440°C, 20 min) aluminium layer. The front side of the substrate was covered with a ZnS/MgF₂ anti-reflective (AR) coating. The annealed aluminium layer at the back gives a relatively low reflection of a maximum of 20 percent at 1800 nm. Using a good reflective metal like gold or silver increases the reflectivity up to 50 percent at 1800 nm. The fact that the effect of the backside reflection only takes place for high wavelengths can be explained by only these photons reaching the backside of the cell.

Since there is a substantial influence of a high surface recombination velocity at the backside of the solar cell, excellent back surface passivation is desirable. This can be achieved by applying, e.g., a thin (50 nm) layer of amorphous silicon by PECVD. This passivation layer is located between the germanium substrate and the metal layer at the back, and lowers the reflectance by 10% when compared to the metal layer only, but the reflectance is still twice as good when compared to the annealed aluminium contact.

Different combinations of firing techniques can be employed on the front and back surfaces. For example, on the front side the metal can be patterned and fired by an overall heating step, or by an overall illumination by a laser of the appropriate energy, and on the backside a continuous layer can be applied locally contacting the Ge substrate, by a laser treatment along a predetermined contact pattern. Different metals can be used on the front and back surfaces. In certain embodiments also the back side metal can be patterned and fired by local or general heating, after which an additional mirror layer can be provided in the areas where no back contact is provided. This may require additional patterning or masking. Preferably materials which show good reflection properties can be used for the additional mirror layer, for example, gold (Au), silver (Ag) If the additional mirror layer is to be applied before contact firing, the material is preferably selected such that it does not easily diffuse through the passivation layer and/or into the germanium substrate upon contact firing. It is preferably selected such that the reflectivity of the interface between the additional mirror layer and the passivation layer / germanium substrate is left substantially intact during contact firing.

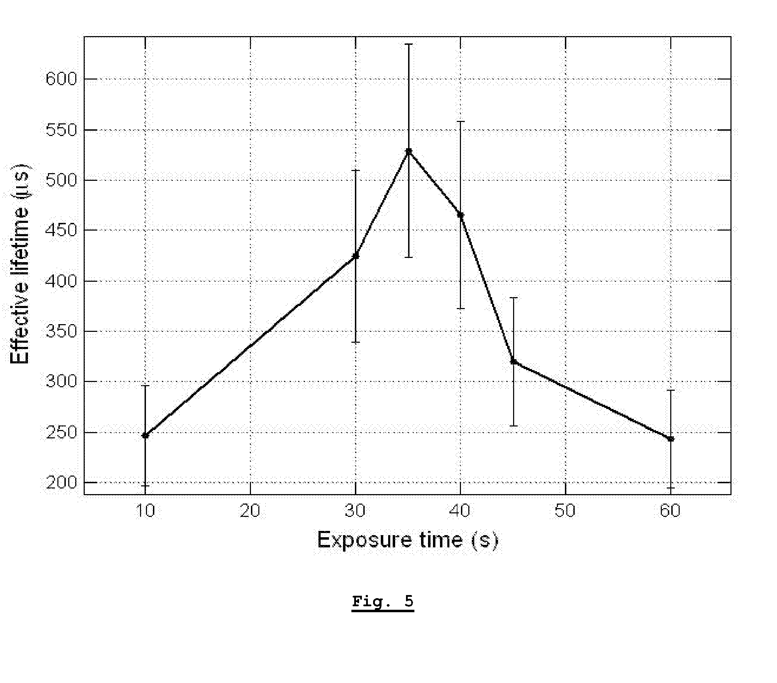

In Fig. 5 the measured effective minority carrier lifetime is plotted in function of the duration of the exposure time of the substrate to the H2 plasma during the preliminary cleaning step. The amount of exposure plays a significant role in the optimization of the solar cell efficiency.

A further improvement of the quality of the passivation can be achieved by optimizing the layer thickness. A layer that is too thin results in lower quality passivation properties, while a layer that is too thick absorbs a larger part of the solar spectrum. For application in a mechanically stacked solar cell, or in a TPV cell the restrictions concerning the thickness are less stringent since in these applications the part of the spectrum that is used by the germanium cell will not be absorbed in the amorphous silicon layer.

A further improvement of the method according to the invention relates to the use of Ag for the back contacts. Advantageously in this case a barrier layer present in between the passivation layer and the contact will be formed.

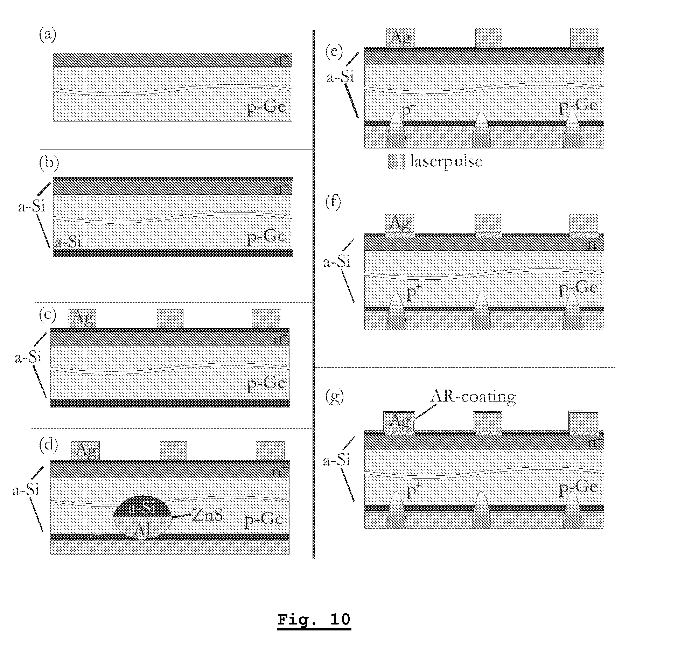

As a preferred embodiment, the cell (so called LFC cell) process that has been developed consists in seven basic steps. A schematic overview of these steps is shown in Fig. 10.

Starting with a bare p-type, 145 µm thick 4-inch germanium substrate, first an n⁺ emitter realized by diffusion of phosphorous from a spin-on dopant which is applied by spin coating, see Fig. 10(a). The diffusion profile is optimized by changing the phosphorous concentration in the spin-on dopant, the spin speed and the diffusion temperature and time. A crucial step for obtaining high cell efficiencies is the passivation of the front and back surface, Fig. 10 (b). A thin layer of amorphous silicon is deposited by application of Plasma Enhanced Chemical Vapour Deposition (PECVD). The surface pre-treatment and plasma conditions are of crucial importance for the quality of amorphous silicon passivation. Subsequently, a palladium (Pd)/silver (Ag) stack is used as a front contact, see Fig. 10(c), where Pd will diffuse through the amorphous silicon layer. The additional layer of silver is used to realize a low series resistance contact.

To realize the highly reflective back contact, a dual layer of zinc-sulfide (ZnS) and aluminium will be applied, see Fig. 10(d). The ZnS layer acts like a diffusion barrier during the subsequent annealing step such that diffusion of aluminium through the amorphous silicon is prevented when annealing the front contact. By changing the thickness of the ZnS layer the back surface reflection can be optimized. As a next step, contact at the backside will be realized by local heating with a laser (Fig. 10(e)). Using this technique the aluminum layer is locally heated and contact is being made through the ZnS and a-Si layer. Subsequently, an annealing is done to diffuse the palladium through the amorphous silicon layer and to anneal the laser fired contact (Fig.10(f)). Optimization of the annealing time is crucial since a too short time does not leave a contact and a too long time results in a shorted cell. As a final step, a dual layer antireflective coating consisting of ZnS and MgF₂ is deposited to increase light transmission into the germanium (Fig.10(g)).

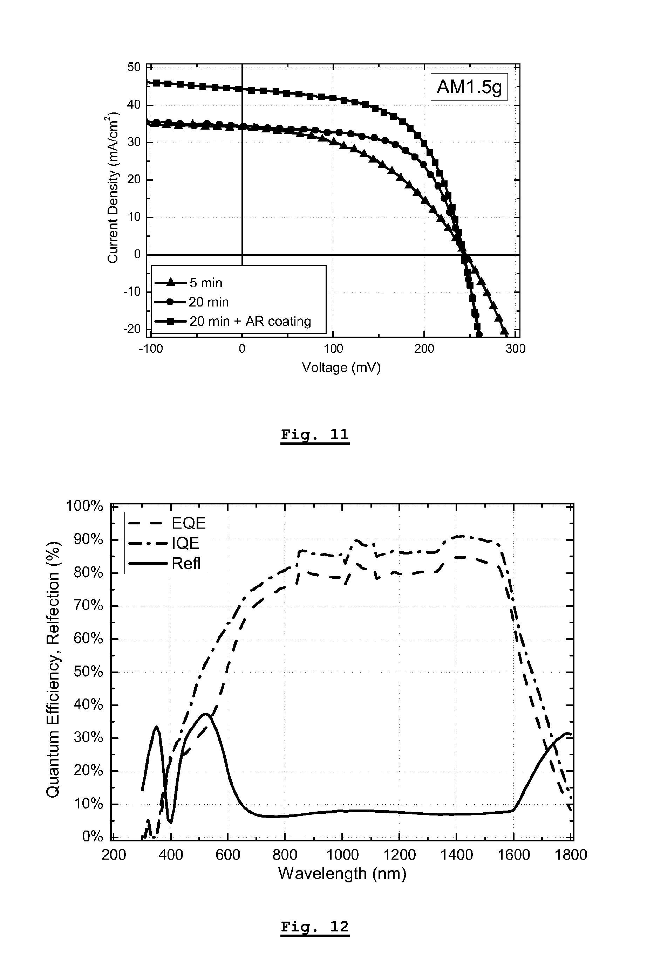

For a LFC contacted cell, the IV characteristics measured at the three different stages is given in Figure 11. These measurements show the formation of the contact at the front by annealing the solar cell. After 5 minutes in 240 °C using Forming Gas (FOG) contact has been realized in the cell but still with a low fill-factor due to a high series resistance, as shown in Figure 11. After a second annealing of 15 minutes, an improvement of the fill-factor was measured, but local shunting of the emitter is expected since the fill factor is non-optimal due to a lowered shunt resistance. It is expected that a total diffusion time of 20 minutes was a bit too high for this specific solar cell. After applying the anti-reflective coating on the cell an improvement of the current is observed without a significant decrease of the fill factor which proves the quality of this contact.

Using the embodiments described above, a LFC contacted thermophotovoltaic cell has been realized with an efficiency of 6.3% and an V_{oc} of 243.1 mV, a J_{sc} of 44.5 mA/cm⁻² and a FF of 58.5% as shown in Figure 11.

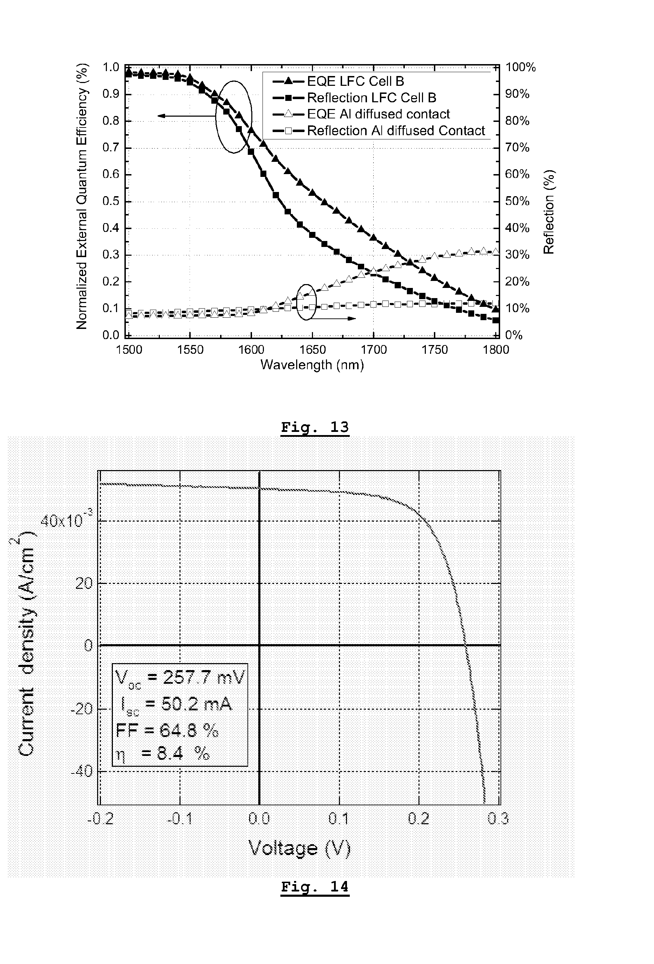

Figures 12 and 13 show the quantum efficiency curves of the LFC contacted cell demonstrating the improved response of this cell in high wavelength regions. The most important motivation for using laser fired contacts in germanium TPV cells is the higher reflectance and thus higher spectral response for incoming photons with high wavelengths. In our "standard" germanium solar cells an aluminium diffused back contact is used. In Figure 13 the reflectance and normalized EQE which has been measured on the two different types of germanium solar cells has been compared. Each cell has the same emitter and front contact grid, but one cell has a diffused aluminium rear contact and the other a LFC contact. One can observe a better EQE for high wavelengths in combination with a higher reflectance. These two improvements lead to a higher efficiency in TPV systems, which was basically the purpose of applying laser fired contacts in germanium.

A 0.5×0.5 cm² cell has been realized with a record efficiency of 8.4 percent, with a J_{sc} of 50 mA/cm², a V_{oc} of 258 mV and a FF of 65 percent. This cell has been separated from other cells by dicing using a diamond wafer dicer. The IV-curve of this cell is shown in Figure 14.

The above description discloses several methods and materials of the present invention. This invention is susceptible to modifications in the methods and materials, as well as alterations in the fabrication methods and equipment. Such modifications will become apparent to those skilled in the art from a consideration of this disclosure or practice of the invention disclosed herein. Consequently, it is not intended that this invention be limited to the specific embodiments disclosed herein, but that it cover all modifications and alternatives coming within the true scope and spirit of the invention as embodied in the attached claims.

## Claims

1. A method of passivating and contacting a surface of a germanium substrate, comprising the following steps:
a) providing a germanium substrate having a first surface;
b) depositing or forming a first layer of an amorphous silicon material on said first surface in order to form a passivation layer;
c) depositing or forming a second layer on said first layer in order to form a contact layer, said contact layer comprising a first metal layer, the first metal layer comprising at least one element selected from the group consisting of palladium, copper and aluminium; and
d) heating the substrate and the layers there on so that the first surface makes contact with the contact layer through the passivation layer.

2. The method according to claim 1, wherein a contact resistivity of a conductive path between the contact layer and the substrate is less than about 10⁻⁴Ωcm².

3. Method according to claim 1 or 2, further comprising the step of cleaning the first surface before depositing or forming the passivation layer, the cleaning step comprising applying a H₂ containing plasma to the first surface.

4. Method according to any of the previous claims, further comprising the step of cleaning the first surface before the step of depositing or forming the passivation layer, the cleaning step comprising applying a wet-HF dip to the first surface.

5. The method according to any of the previous claims, wherein forming the passivation layer is performed by plasma enhanced chemical vapour deposition.

6. The method according to claim 5, wherein the plasma enhanced chemical vapour deposition is performed at a temperature of from about 150°C to about 300°C.

7. The method according to any of the previous claims, wherein the passivation layer has a thickness of less than about 100 nm.

8. The method according to claim 7, wherein the passivation layer has a thickness of less than about 80 nm.

9. The method according to claim 8, wherein the passivation layer has a thickness of less than about 40 nm.

10. The method according to claim 7, wherein the passivation layer has a thickness of from about 10 nm to about 50 nm.

11. The method according to claim 7, wherein the passivation layer has a thickness of from about 20 nm to about 100 nm.

12. The method according to any of the previous claims, wherein the first metal layer comprises palladium and wherein the contact layer further comprises an additional metal layer, the additional metal layer comprising at least one element selected from the group consisting of copper, silver, and gold.

13. The method according to any of the previous claims, wherein the first metal layer is deposited atop the passivation layer, and wherein the additional metal layer is deposited atop the first metal layer.

14. The method according to any of the previous claims, wherein the first metal layer consists essentially of aluminium and wherein the first surface is configured to be used as a back surface of a photovoltaic device.

15. The method according to any of the previous claims, wherein the heating step of the substrate and the layers there on is performed locally, in a predetermined contact area.

16. The method according to claim 15, wherein the heating step is performed by a laser.

17. The method according to any of the previous claims, wherein the contact layer is a continuous layer configured for use as a mirroring surface for the back surface.

18. The method according to any of the previous claims, further comprising the deposition of a barrier layer between said passivation layer and said contact layer.

19. The method according to claim 18, wherein said barrier layer comprises ZnS, MgF, SiOₓ or SiₓN_{y}.

20. The method according to any of the previous claims, wherein the heating step is performed at a temperature lower than about 500°C, preferably lower than about 400°C, and more preferably lower than about 300°C.

21. The method according to any of the previous claims, wherein the heating step is performed at a temperature of from about 180°C to about 240°C.

22. A passivated germanium substrate, comprising:
i. a germanium substrate comprising a first surface;
ii. a passivation layer comprising an amorphous silicon material formed on the first surface; and
iii. a metal contacting layer on the passivation layer, the metal contacting layer contacting the substrate through the passivation layer, by particles of the metal that are penetrated into the passivation layer to form a conductive path between the contacting layer and the germanium substrate, wherein the contacting layer comprises a first metal layer, the first metal layer comprising at least one element selected from the group consisting of palladium, copper and aluminium.

23. The substrate according to claim 22, wherein the passivation layer comprises a conductive material in an area underlying the contacting layer and between the contacting layer and the germanium substrate.

24. The substrate according to claim 22 or 23, wherein the passivation layer has a thickness of from about 10 nm to about 40 nm.

25. The substrate according to claim 22 or 23, wherein the passivation layer has a thickness of from about 20 nm to about 100 nm.

26. A photovoltaic device comprising a substrate according to any of claims 22 to 25.

27. A photovoltaic device comprising:
i. a germanium substrate having a first surface and a second surface;
ii. a first passivation layer comprising amorphous silicon material formed on the first surface;
iii. a second passivation layer comprising amorphous silicon material formed on the second surface;
iv. a first contacting layer comprising a conductive material formed on the first passivation layer, wherein the first contacting layer comprises aluminium; and
v. a second contacting layer comprising a conductive material formed on the second passivation layer, wherein the second contacting layer comprises at least one metal element selected from the group consisting of Pd, Cu, Ag, and Au.

28. The photovoltaic device according to claim 27, further comprising a barrier layer in between said first or second contact layer and said first or second passivation layer.

29. The photovoltaic device according to claim 28, wherein said barrier layer comprises ZnS, MgF, SiOₓ or SiₓN_{y}.

30. A method of passivating and contacting a surface of a germanium substrate, comprising:
(a) providing a germanium substrate having a first surface;
(b) forming a passivation layer of an amorphous silicon material on the first surface;
(c) forming a contact layer on the passivation layer, wherein the contact layer comprises a first metal layer,
(d) heating the substrate and the layers so that the first surface makes contact with the contact layer through the passivation layer,
wherein heating the substrate and the layers is performed locally, in a predetermined contact area.

31. The method according to claim 30, wherein heating is performed by a laser.

32. The method according to any of claims 30 to 31, wherein the contact layer is a continuous layer configured for use as a mirroring surface for the back surface.
